(19) Europäisches Patentamt
European Patent Office
Office européen des brevets

(11) EP 3 636 689 A1

(12) EUROPEAN PATENT APPLICATION
published in accordance with Art. 153(4) EPC

(43) Date of publication:
**15.04.2020 Bulletin 2020/16**

(21) Application number: **18812937.3**

(22) Date of filing: **01.06.2018**

(51) Int Cl.:
***C08G 61/12*** *(2006.01)* ***H01L 51/50*** *(2006.01)*

(86) International application number:
**PCT/JP2018/021155**

(87) International publication number:
**WO 2018/225640 (13.12.2018 Gazette 2018/50)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **06.06.2017 JP 2017111265**

(71) Applicant: **Hitachi Chemical Company, Ltd.**
**Chiyoda-ku**
**Tokyo 100-6606 (JP)**

(72) Inventors:
- **SANO, Akihiro**
  **Tokyo 100-8280 (JP)**
- **YOSHINARI, Yuki**
  **Tokyo 100-6606 (JP)**

(74) Representative: **MERH-IP Matias Erny Reichl Hoffmann**
**Patentanwälte PartG mbB**
**Paul-Heyse-Strasse 29**
**80336 München (DE)**

# (54) CURABLE POLYMER, POLYMERIZATION LIQUID, CONDUCTIVE FILM AND ORGANIC LIGHT EMITTING ELEMENT

(57) An object of the present invention is to improve the service life of an organic light emitting element. In order to solve the above problem, a curable polymer according to the present invention includes a macromolecule including a main chain (1) having a conjugating monomer and a side chain (2) having a crosslinking group, and the macromolecule is doped with holes (3).

FIG. 1

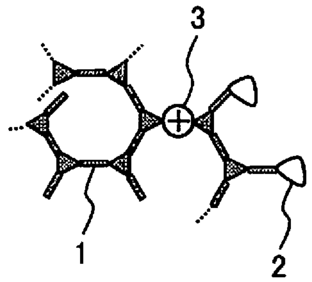


EP 3 636 689 A1

**Description**

Technical Field

The present invention relates to a curable polymer, a polymerization liquid, a conductive film, and an organic light emitting element.

Background Art

An organic light emitting element has attracted attention as an element providing thin, lightweight, and flexible lighting and display by using an organic solid material tens of nm in thickness. Further, an organic light emitting element can have a high viewing angle because it is self-luminous, is suitable for high-speed moving image display because the response speed of the self-luminous body itself is high, and hence is expected as a next-generation flat panel display or sheet display. Moreover, an organic light emitting element has attracted attention as next-generation lighting because light can be emitted uniformly from a large area.

In an organic light emitting element, holes are injected from an anode and electrons are injected from a cathode into an organic laminated film by applying a voltage to an organic film interposed between the anode and the cathode and light is emitted by recombining the holes and the electrons at a light emitting layer.

An organic light emitting element comprises an anode, a hole transport layer for transporting holes from the anode to a light emitting layer, the light emitting layer, an electron transport layer for transporting electrons from a cathode to the light emitting layer, and the cathode. In order to efficiently inject the electrons and the holes into the light emitting layer, a plurality of different films may sometimes be stacked as the hole transport layer and the electron transport layer respectively. In the organic light emitting element, not only the light emitting layer but also the hole transport layer and the electron transport layer are stacked by using organic solids.

A method for stacking organic solid materials in an organic light emitting element is roughly classified into a vacuum deposition process and a wet process. In comparison with the vacuum deposition process, the wet process represented by a printing method or an inkjet method is expected because of the advantages of mass productivity, cost reduction in manufacturing processes, and expandability of a screen size. A problem of stacking organic films in the wet process is that an already formed layer dissolves when a next layer is formed. As a countermeasure, there is a method of dissolving a curable polymer including an organic molecule to which a curable crosslinking group is added in a solvent and applying the curable polymer through a wet process, and then curing the organic molecule by heat or light treatment. Since a cured film has the nature of hardly dissolving in a solvent, the stacking of organic films in a wet process is facilitated.

As conventional technologies of curing an organic molecule in an organic light emitting element, there are following technologies.

PTL 1 describes that a polymer of a specific structure having an alkylene group (quaternary carbon) in a main chain and having a crosslinkable group can be stacked by a wet film forming method, and even after the polymer is crosslinked and is made insoluble in an organic solvent, a singlet excitation level and a triplet excitation level are high and the polymer has high hole transport performance and electrochemical stability. Further, PTL 1 describes that, in a hole injection layer adjacent to an anode in a plurality of hole transport layers, an electrical conductivity improves by including an electron acceptable compound having oxidizability and having an ability of accepting electrons from a hole transportable compound.

PTL 2 describes that protons or other cationic molecular impurities existing in a doped polymer that is made conductive by Bronsted acid or the like constitute intrinsic holes. PTL 2 indicates that protons or other cationic molecular impurities diffuse from a doped polymer into other layers and are a limiting factor for the service life of an electronic device, and describes that characteristics such as a service life can be improved by forming at least one crosslinkable undoped polymer buffer layer between an electrically conductive doped polymer and an organic semiconductor layer.

Citation List

Patent Literature

PTL 1: WO 2011/099531
PTL 2: Japanese Unexamined Patent Application Publication No. 2013-191867

## Summary of Invention

### Technical Problem

In a polymer that improves the electrical conductivity of a hole injection layer as shown in PTL 1 or a doped polymer as shown in PTL 2, an electron accepting compound or a chemical compound having oxidizability such as Bronsted acid or the like is included in the polymer and a hole transport layer is doped with holes. When a chemical compound having such oxidizability remains in a film after the film is formed as shown in PTL 2, however, a service life is shortened. PTL 2 describes that a service life can be improved by forming a buffer layer but the film thickness of an element increases by as much as the buffer layer and the drive voltage of an organic light emitting element increases.

### Solution to Problem

In order to solve the above problems, a curable polymer according to the present invention includes a macromolecule including a main chain having a conjugating monomer and a side chain having a crosslinking group, and is doped with holes.

### Advantageous Effects of Invention

An organic light emitting element in which a hole transport layer is formed by using a curable polymer according to the present invention has a better service life characteristic than before.

## Brief Description of Drawings

Figure 1 is a first schematic view showing a macromolecular structure of a curable polymer according to the present embodiment.
Figure 2 is a second schematic view showing a macromolecular structure of a curable polymer according to the present embodiment.
Figure 3 is a sectional view showing an embodiment of an organic light emitting element in the present embodiment.
Figure 4 is a third schematic view showing a macromolecular structure of a curable polymer according to the present embodiment.
Figure 5 is a schematic view showing a hole only element and an impedance measurement system.

## Description of Embodiments

Best modes for carrying out the present invention are explained hereunder.

<Definition of curable polymer>

In the present embodiment, a "curable polymer" means a molecule that can commence the crosslinking reaction of a macromolecule in which a crosslinking group is combined with a side chain and can form intermolecular crosslinking or intramolecular crosslinking by applying curing treatment of heat or light after a substrate is coated with the molecule, and indicates a curable polymer in the state before curing reaction occurs.

Figure 1 is a first schematic view showing a macromolecular structure of a curable polymer according to the present embodiment. In Figure 1, a main chain of a macromolecule comprises a conjugating main chain 1 consisting of the repetition of chain-like and branched conjugating monomers. In the macromolecule, a crosslinking group 2 of epoxy, oxetane, benzocyclobutene, styrene, or the like is added to a side chain. Further, in a macromolecule of a curable polymer according to the present embodiment, the conjugating main chain 1 is chemically doped with a hole 3 by a method described later.

Figure 2 is a second schematic view showing a macromolecular structure of a curable polymer according to the present embodiment. A main chain of a macromolecule may also be configured by a linear conjugating main chain 1 comprising a chain-like conjugating monomer as shown in Figure 2 as long as the curability of a resin after cured is not hindered. A crosslinking group 2 is added to a side chain of the macromolecule. The conjugating main chain 1 of the macromolecule is chemically doped with a hole 3. Otherwise, a macromolecule of a curable polymer may also be configured by a mixture of a macromolecule of Figure 1 and a macromolecule of Figure 2.

An example of the structure of an organic light emitting element is shown in Figure 3. An organic light emitting

element 301 has a structure formed by stacking a glass substrate 31, an anode 32, a hole transport layer 33, a light emitting layer 34, an electron transport layer 35, a cathode 36, and a sealing glass,plate 37.

In forming a laminated structure, when another organic layer is stacked over a base organic layer through a wet process, the base organic layer dissolves undesirably. As a countermeasure, by applying curing treatment by heat or light to a base organic layer beforehand, the dissolution of the base organic layer can be avoided even when another organic layer is stacked over the base organic layer through a wet process. A plurality of hole transport layers 33 may be formed and a plurality of electron transport layers 35 may also be formed. In the multiple hole transport layers, a layer adjacent to the anode is called a hole injection layer and a layer adjacent to the light emitting layer is called a hole transport layer in many cases but in the present embodiment both the layers are collectively called a hole transport layer.

<Main chain of macromolecule of curable polymer>

As a conjugating monomer included in a main chain of a macromolecule of a curable polymer according to the present embodiment, a known monomer used for manufacturing a resin for forming a hole transport layer, a light emitting layer, and an electron transport layer in an organic light emitting element can be used, for example. The conjugating monomer has charge transportability or luminescence.

As a conjugating monomer, named can be, for example, arylamine, stilbene, hydrazone, carbazole, aniline, oxazole, oxadiazole, benzoxazole, benzoxadiazole, benzoquinone, quinoline, isoquinoline, quinoxaline, thiophene, benzothiophene, thiadiazole, benzodiazole, benzothiadiazole, triazole, perylene, quinacridone, pyrazoline, anthracene, rubrene, coumarin, naphthalene, benzene, biphenyl, terphenyl, anthracene, tetracene, fluorene, phenanthrene, pyrene, chrysene, pyridine, pyrazine, acridine, phenanthroline, furan, pyrrole, or a chemical compound having a derivative of those materials as the skeleton.

More desirably, a conjugating monomer is any one of the following chemical formulae (1) to (3).

[Chem. 1]

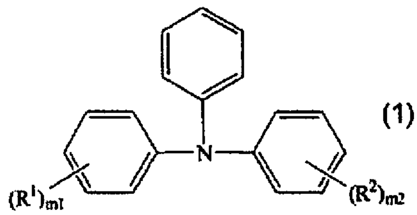 (1) 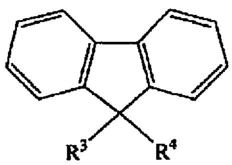 (2) 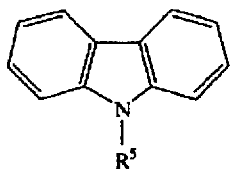 (3)

In the formulae, $R^1$ to $R^5$ are selected independently from each other: desirably from the group consisting of hydrogen, halogen, cyano, nitro, linear, branched, or cyclic alkyl having 1 to 22 carbon atoms, linear, branched, or cyclic alkenyl having 2 to 22 carbon atoms, linear, branched, or cyclic alkynyl having 2 to 22 carbon atoms, aryl having 6 to 21 carbon atoms, heteroaryl having 12 to 20 carbon atoms, aralkyl having 7 to 21 carbon atoms, and heteroarylalkyl having 13 to 20 carbon atoms; more desirably from the group consisting of hydrogen, halogen, cyano, nitro, linear, branched, or cyclic alkyl having 1 to 22 carbon atoms, aryl having 6 to 21 carbon atoms, heteroaryl having 12 to 20 carbon atoms, and aralkyl having 7 to 21 carbon atoms; yet more desirably from the group consisting of hydrogen, halogen, linear, branched, or cyclic alkyl having 1 to 10 carbon atoms, and aryl having 6 to 10 carbon atoms; and particularly desirably from the group consisting of hydrogen, bromine, methyl, ethyl, propyl, butyl, pentyl, hexyl, heptyl, octyl, nonyl, decyl, and phenyl.

Each of the above groups is desirably not replaced or replaced with one or more halogens, and more desirably not replaced.

Each of m1 and m2 is independently from each other desirably an integer of 0 to 5, and more desirably 0 or 1.

In the present embodiment, "aralkyl" means a group formed by replacing one of the hydrogen atoms in alkyl with aryl. A suitable aralkyl is not limited and benzyl, 1-phenethyl, or 2-phenethyl is named, for example.

In the present embodiment, "arylalkenyl" means a group formed by replacing one of the hydrogen atoms in alkenyl with aryl. A suitable arylalkenyl is not limited and styryl or the like is named, for example.

In the present embodiment, "heteroaryl" means a group formed by replacing independently from each other at least one carbon atom in aryl with a heteroatom selected from a nitrogen atom (N), a sulfur atom (S), and an oxygen atom (O). For example, each of "heteroaryl having 12 to 20 carbon atoms" and "heteroaryl having 12 to 20 (ring) members" means a group formed by replacing independently from each other at least one carbon atom in an aromatic group including at least 12 and at most 20 carbon atoms with the above heteroatom. On this occasion, replacement with N or S includes replacement with N-oxide or oxide or dioxide of S respectively. Suitable heteroaryl is not limited, and furanyl,

thienyl, pyrrolyl, imidazolyl, pyrazolyl, triazolyl, tetrazolyl, thiazolyl, oxazolyl, isoxazolyl, oxadiazolyl, thiadiazolyl, isothiazolyl, pyridyl, pyridazinyl, pyrazinyl, pyrimidinyl, quinolinyl, isoquinolinyl, indolyl, or the like can be named, for example.

In the present embodiment, "heteroarylalkyl" means a group formed by replacing one hydrogen atom in alkyl with heteroaryl. In the present embodiment, "halogen" means fluorine, chlorine, bromine, or iodine.

Specifically desirably, a conjugating monomer is selected from triphenylamine, N-(4-butylphenyl)-N',N"-diphenylamine, 9,9-dioctyl-9H-fluorene, N-phenyl-9H-carbazole, N,N'-diphenyl-N,N'-bis(3-methylphenyl)-[1,1'-biphenyl]-4,4'-diamine, N,N'-bis(3- methylphenyl)-N,N'-bis(2-naphthyl)-[1,1'-biphenyl]-4,4'-diamine, and a chemical compound having a derivative of those materials as the skeleton.

By using a macromolecular composition comprising a main chain of a conjugating monomer having the aforementioned skeleton as a hole transport layer, it is possible to adjust the ionization energy of the hole transport layer to an appropriate value in conformity with the ionization energy of a light emitting layer material. Usually, a value between the work function of an anode and the ionization energy of a light emitting layer or a value larger than the ionization energy of a light emitting layer is suitable.

<Crosslinking group of curable polymer>

As a crosslinking group included in a side chain of a curable polymer according to the present embodiment, a known crosslinking group can be used. For example, a cyclic ether group represented by an epoxy group or an oxetane group or a crosslinking group that promotes Diels-Alder type crosslinking reaction is acceptable and a combination of those crosslinking groups is also acceptable. A crosslinking group that promotes Diels-Alder type crosslinking reaction is not limited and a crosslinking group having thiophene, styrene, pyrrole, or benzocyclobutene as the skeleton can be named, for example.

<Hole dopant>

As a typical hole dopant used for doping a curable polymer with holes, there is a dopant having a role as an ionic polymerization initiator that crosslinks a crosslinking group by cationic molecular polymerization. An ionic polymerization initiator that crosslinks a crosslinking group by cationic molecular polymerization comprises a combination of a positively charged cationic molecule and a negatively charged counter anionic molecule (hereunder referred to as an ionic polymerization initiator, including ions remaining in a cured resin after cured among those ions). In a cationic molecule, chemical reaction is activated by heating or light irradiation treatment. An anionic molecule is added in order to keep the positive charge of a cationic molecule neutral and is stable in a negatively charged state. An activated cationic molecule causes chemical reaction that accepts one electron from a macromolecule of a curable polymer, and the macromolecule is chemically doped with holes.

Figure 4 is a third schematic view showing a macromolecular structure of a curable polymer according to the present embodiment. A cationic molecule and an anionic molecule included in an ionic polymerization initiator before crosslinking exist at a molar ratio of 100:100. After crosslinking, the cationic molecule that has contributed to the doping of holes changes to a cationic decomposition product, and the cationic molecule that has not contributed to the doping of holes remains as it is. Assuming that the cationic molecule of x moles that has contributed to the doping of holes remains, the cationic molecule, the cationic decomposition product, and the anionic molecule exist at a molar ratio of x:(100-x):100. Since it is better not to include an unreacted ionic polymerization initiator, the molar concentration of a cationic molecule after crosslinking is desirably 0.1 times or less of an anionic molecule.

An ionic polymerization initiator is used as a hole dopant in the following explanation, but the hole dopant according to the present embodiment is not limited to that and may also be a known electron accepting compound or a chemical compound having oxidizability such as Bronsted acid or the like. In the following examples, a chemical compound having oxidizability in an ionic polymerization initiator indicates a cationic molecule unless otherwise specified. As a hole dopant of an ionic polymerization initiator, iodonium salt, sulfonium salt, or a ferrocene derivative can be named, for example.

Specifically desirably, an ionic polymerization initiator is selected from the chemical compounds represented by the following chemical formulae (4) to (6).

[Chem. 2]

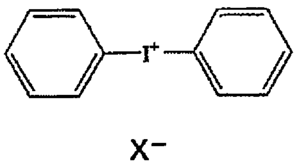 (4) 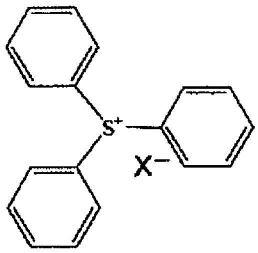 (5) 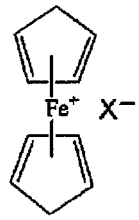 (6)

$X^- = Sb_6^-$、$(C_6F_5)_4B^-$、$CF_3SO_3^-$、$PF_6^-$、$BF_4^-$、
$C_4F_9SO_3^-$、$CH_3C_6H_4SO_3^-$

<Macromolecule doped with holes>

A curable polymer according to the present embodiment is a curable polymer before crosslinking, and a curable polymer including a macromolecule having a conjugating monomer in a main chain and a crosslinking group in a side chain and being doped with holes.

<Procedure 1: Hole doping>

A plurality of hole dopants are added to a solution including a macromolecule having a conjugating monomer in a main chain and a crosslinking group in a side chain (hereunder this process is referred to as "hole doping"). The hole dopants include a chemical compound having oxidizability. The hole doping indicates chemical reaction caused by the oxidizability. In the hole doping, crosslinking reaction such as ring opening of a crosslinking group may desirably not be promoted.

<Procedure 2: Separation and removal of unreacted oxidizable compound>

A plurality of hole dopants are added in Procedure 1 but not all the hole dopants contribute to hole doping, and some of the hole dopants remain unreacted. A solution is produced by dissolving a curable polymer after hole doping in a solvent (for example, toluene). In the solution, an oxidizable compound component included in the hole dopants remaining unreacted is removed. In the case of using an ionic polymerization initiator as a hole dopant, the chemical compound component having oxidizability is a cationic molecule.

Means for removing such a chemical compound component is not particularly limited, and a solvent extraction method or a centrifugal method is named, for example.

For example, a macromolecular material used for an organic light emitting element is often soluble in a nonpolar organic solvent such as toluene. In contrast, a cationic molecule and an anionic molecule in an ionic polymerization initiator have electric charge and hence tend to dissolve in a polar solvent such as acetone. In Procedure 1, a solvent (for example, toluene) is evaporated from a solution including a curable polymer in which hole doping reaction has proceeded. A residual component is dissolved again in another solvent (for example, acetone). The cationic molecule and the anionic molecule dissolve in the solvent, and the macromolecule doped with holes is precipitated together with the macromolecule not doped with holes. On this occasion, an anion having the same molecule number as the molecule number of the macromolecule doped with positively charged holes is physically coprecipitated.

By repeating the process, an unreacted compound component having oxidizability (cationic molecule) can be separated and removed with a high degree of purity.

<Crosslinking reaction>

When an ionic polymerization initiator is added as means for accelerating crosslinking reaction, a cationic molecule that is an unreacted compound component having oxidizability may remain as it is. In the present embodiment, curing treatment is desirably applied at a higher temperature. As another means for accelerating crosslinking reaction, there is means of using a neutral catalyst. For example, means of using an acetylacetonate-based metal complex as a basic catalyst is named. A catalyst is not a reactant that produces a decomposition product by itself and hence can suppress influence on a service life even if the catalyst remains in a film.

<Measurement of hole density $n_0$>

A hole density in a layer formed by using a curable polymer doped with holes can be measured by the following method, for example. An element having a structure in which a hole transport layer is interposed between electrodes such as an anode ITO and a cathode Al is called a hole only element. By the difference between the work function (usually 5 eV or more) of a hole transport layer and the work function (4.2 eV) of Al, a region of a low hole density (referred to as a depletion layer) is formed on the hole transport layer side at the interface between the hole transport layer and Al. The thickness d' of the depletion layer is given by the following numerical expression (7).
[Num. 1]

$$d' = \left\{ \frac{2\varepsilon\varepsilon_0(\Delta\phi - V)}{en_0} \right\}^{\frac{1}{2}} \qquad (7)$$

Here, $\Delta\Phi$ represents a difference between the work functions of a hole transport layer and Al and V represents a voltage applied to an anode and a cathode, $\varepsilon_0$ represents a dielectric constant of vacuum and $\varepsilon$ represents a relative dielectric constant of a formed layer.
A capacitance C' in a depletion layer is given by the following numerical expression (8).
[Num. 2]

$$C' = \frac{\varepsilon \cdot \varepsilon_0 \cdot S}{d'} \qquad (8)$$

Here, S represents an area of an element. A hole density no is obtained by applying a voltage to an anode and a cathode and measuring a capacitance.
Figure 5 is a schematic view showing a hole only element and an impedance measurement system. A capacitance derived from a depletion layer can be separated by measuring the frequency dependence of an impedance of a hole only element 401 with an LCR meter 402.

<Organic light emitting element>

Figure 3 is a sectional view showing an embodiment of an organic light emitting element in the present embodiment. An organic light emitting element 301 according to the present embodiment has an anode 32, a cathode 36, a light emitting layer 34 arranged between the anode 32 and the cathode 36, and a hole transport layer 33 (also referred to as "hole injection layer" occasionally) arranged between the anode 32 and the light emitting layer 34. The anode 32 is formed by patterning indium tin oxide (ITO) over a glass substrate 31, for example. The cathode 36 is formed by forming the hole transport layer 33 and the light emitting layer 34 in sequence over the anode 32 of the ITO glass substrate 31 and then evaporating aluminum (Al) over the light emitting layer 34, for example. An organic light emitting element 301 according to the present embodiment is desirably sealed by: interposing an anode 32, a hole transport layer 33, a light emitting layer 34, an electron transport layer 35, and a cathode 36 between a glass substrate 31 and a sealing glass plate 37; and then pasting the glass substrate 31 and the sealing glass plate 37 by using a curable resin such as a photocurable epoxy resin, for example.
In an organic light emitting element according to the present embodiment, a hole transport layer is produced by using a resin comprising a crosslinkable polymer. The hole transport layer can be produced by using means commonly used in the art. For example, the hole transport layer may be produced by: coating an anode patterned over a glass substrate with a curable polymer according to the present embodiment through a wet process of a spin coating method, a printing method, an inkjet method, or the like; and then forming a resin by the curing treatment explained above. A resin formed from a polymerization liquid is highly curable and excellent in organic solvent resistance. As a result, when a light emitting layer is stacked over the surface of a hole transport layer produced by using the resin described above through a wet process for example, the hole transport layer can be inhibited from being dissolved by an organic solvent included in the coating solution of the light emitting layer. For example, a residual film ratio of a hole transport layer produced by using a resin formed by a curable polymer according to the present embodiment is usually in the range of

60% to 100% and typically in the range of 80% to 99%. A resin having organic solvent resistance represented by the above residual film ratio is highly curable. By using a resin according to the present embodiment for a hole transport layer therefore, the productivity of an organic light emitting element through a wet process can be improved.

Meanwhile, a residual film ratio can be evaluated through the following procedure, for example. A hole transport layer is produced by using a resin formed by a curable polymer according to the present embodiment and an ionic polymerization initiator over an anode of an ITO glass substrate. The ITO glass substrate over which the hole transport layer is formed is immersed in an organic solvent (for example, toluene) under the conditions of 20°C to 250°C and 10 to 60 seconds. Successively, the ITO glass substrate was taken out from the organic solvent, and the absorbances of a thin film before and after the immersion were measured. From the ratio of the absorbances, the residual ratio of the thin film (residual film ratio) was obtained. Since an absorbance is proportional to a film thickness, a ratio of absorbances (with immersion/without immersion) coincides with a residual film ratio (with immersion/without immersion) of a hole transport layer. Organic solvent resistance is evaluated to be higher as a residual film ratio increases. Examples

The present embodiment is hereunder explained more specifically by using examples. The technical scope of the present embodiment, however, is not limited to those examples.

<Example 1: First curable polymer including macromolecule doped with holes>

[Synthesis of macromolecule of crosslinkable polymer]

A crosslinkable polymer was synthesized by polymerizing a linear triphenylamine monomer (the following chemical formula (9)), a branched triphenylamine monomer (the following chemical formula (10)), and an oxetane crosslinking monomer (the following chemical formula (11)) by Suzuki reaction. The linear triphenylamine monomer (chemical formula (9)) has two reaction sites of Suzuki reaction, and forms a main chain by the polymerization. The branched triphenylamine monomer (chemical formula (10)) has three reaction sites of Suzuki reaction, and forms a main chain by the polymerization. The oxetane crosslinking monomer (chemical formula (11)) has one reaction site of Suzuki reaction, and forms a side chain by the polymerization. The crosslinkable oxetane crosslinking monomer (chemical formula (11)) is a monomer having a structure in which a 1-ethyloxetane-1-yl group is bonded to a bivalent crosslinking group comprising a combination of phenylene and oxymethylene.

[Chem. 3]

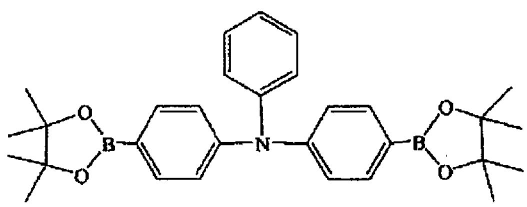

(9)

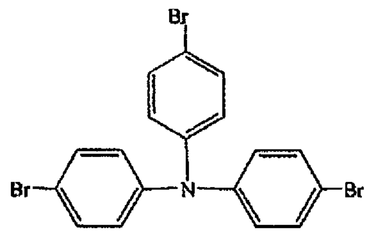

(10)

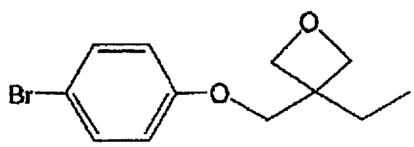

(11)

4,4'-bis(4,4,5,5-tetramethyl-1,3,2-dioxaborolane-2-yl)-4"-n-butyltriphenylamine (9) (0.4 mmol), 4,4',4"-triburomotriphenylamine (10) (1.0 mmol), 3-(4-bromophenoxymethyl)3-ethyloxetane (11) (1.2 mmol), tetrakistriphenylphosphine palladium (0.008 mmol), 2M potassium carbonate aqueous solution (5.3 mmol), Aliquat (registered trademark) 336 (0.4 mmol), and anisole (4 ml) were put into a round flask and stirred at 90°C for 2 hours under a nitrogen atmosphere.

The crosslinkable linear triphenylamine monomer (chemical formula (9)), the crosslinkable branched triphenylamine monomer (chemical formula (10)), and the crosslinkable oxetane crosslinking monomer (chemical formula (11)) were synthesized at a molar ratio of 20:50:40 by the above method, and resultantly a macromolecular composition A having a crosslinking group of a molecular weight of 40 kDa was obtained. The molecular weight was determined by a number average obtained by using gel permeation chromatography and measuring in polystyrene equivalent.

[Hole doping]

The above curable polymer of 4.2 mg and an ionic polymerization initiator represented by the chemical formula (4) (in the formula, anion X = $(C_6F_5)_4B^-$) of 0.01 mg or 0.05 mg in concentration (corresponding to of 1% or 5% by mass of the curable polymer) are dissolved in toluene of 1.2 ml.

The solution turns slightly pale red when the solution was heated at 120°C for 30 minutes. The pale red is estimated to be derived from the macromolecule doped with holes. Since a precipitate is not seen, the production of a polymer of a high macromolecular weight generated by crosslinking reaction does not proceed. It is estimated therefore that a hole-doped macromolecule including a crosslinking group in which crosslinking reaction does not proceed is produced in the solution.

[Separation and removal of unreacted chemical compound having oxidizability]

The solution including the curable polymer was applied over a glass substrate by spin coating under the condition of 300 rpm and the toluene that was the solvent was vaporized. The pale red solid body remaining over the glass was dissolved again in a chloroform solvent, and resultantly an aggregate that further turns pale red was precipitated.

[Analysis of solvent residual component]

In the above solution, the infrared absorption spectrum of the component dissolving in the solvent was analyzed and resultantly an absorption peak derived from an iodonium compound in the ionic polymerization initiator represented by the chemical formula (4) was recognized. In contrast, an absorption peak derived from triphenylamine represented by the chemical formulae (9) and (10) was not detected. It was therefore found that the precipitated pale red solid body was a mixture of a macromolecule including holes and a macromolecule not including holes in the macromolecule having triphenylamine as the main chain. Further, because the iodonium compound was selectively observed in the solution, the unreacted chemical compound having oxidizability could be separated and removed.

By repeating the process of dissolving the precipitate again in the chloroform solution and recovering the precipitate, the unreacted chemical compound having oxidizability can be separated and removed with a high degree of purity.

[Curable polymer doped with holes]

By recovering the above precipitate, a curable polymer including the macromolecule doped with hole according to the present embodiment was obtained.

[Preparation of polymerization solution]

The recovered curable polymer including the macromolecule doped with holes of 2.1 mg is dissolved in toluene of 1.2 ml.

[Production of conductive film using curable polymer doped with holes]

Indium tin oxide (ITO) was patterned over a glass substrate at a width of 1.6 mm. Over the ITO glass substrate, the aforementioned coating solution was applied by spin coating under the condition of 300 rpm. Successively, The ITO glass substrate coated with the crosslinkable polymer was heat-treated over a hot plate under the following three different conditions (A: no heating, B: heating at 120°C for 10 minutes, C: heating at 200°C for 10 minutes) and then the characteristics of the films were examined.

[Evaluation of residual film ratio]

Each of the films produced under the respective heating conditions was rinsed together with the glass substrate in toluene, the absorbances before and after the rinse of the film were measured, and the residual ratio of the thin film (residual film ratio) was obtained from the ratio of the absorbances before and after the rinse. Whereas the residual film ratios of the films of (A) and (B) were 30% or less, the residual film ratio of the film of (C) was 90% or more. This shows that the curable polymer including the macromolecule doped with holes is a curable polymer that exhibits curability at least by heating of 200°C or higher. The temperature dependency of the residual film ratio was similar to that of the residual film ratio of a curable polymer not doped with holes shown in Comparative Example 1. It is estimated that the curing of a crosslinking group proceeds with a small amount of residual initiator in the process of separating and removing

an unreacted chemical compound having oxidizability.

[Production of hole only element]

An Al electrode 100 nm in film thickness was evaporated further over each of the films of (A), (B), and (C). The element is called a hole only element.

[Measurement of hole density no]

The capacitance of a hole only element was measured by using an LCR meter 402 (NF circuit block ZM2376) as shown in Figure 5. In any of the elements, a capacitance component of 4±0.2×10-9 [F] was observed in the range of 0.1 to 100 Hz under an applied voltage of 0 V. The capacitance increased when voltage was given in the range of 0 to 0.8 V with the anode positive and the cathode negative. In contrast, the capacitance reduced when voltage was given in the range of 0 to 2.5 V with the anode negative and the cathode positive. From the results, it was clarified that a depletion layer was formed at the interface on the Al side of the conductive film. A hole density $n_0$ was calculated by using the numerical expressions (7) and (8).

In the case of the films where the concentration of the ionic polymerization initiator was 1% by mass, in any of the hole only elements of (A), (B), and (C), $3\pm0.3\times10^{17}$ [pieces/$cm^3$] was obtained, and conductive films doped with holes were obtained. Further, in the case of the films where the concentration of the ionic polymerization initiator was 5% by mass, in any of the hole only elements of (A), (B), and (C), $1.4\pm0.2\times10^{18}$ [pieces/$cm^3$] was obtained, and conductive films doped with holes were obtained.

The results show that the curable polymer including the macromolecule doped with holes has been doped with holes in advance without accompanying curing reaction by heating to 200°C. Since the variation of hole concentrations by heating is small, it is estimated that the unreacted cationic molecule is separated sufficiently.

In the design of an organic light emitting element, a hole density is desirably controlled at least with accuracy of 10% or less. If a cationic molecule remaining unreacted exists, that may induce the reaction that causes doped holes to disappear during operation. Assuming that one unreacted cationic molecule causes one hole to disappear, in order for a hole density to keep an initial density with accuracy of 10% or less, it is desirable that the number density of an unreacted cationic molecule is 10% or less of the initial density.

<Example 2: Second curable polymer doped with holes>

A curable polymer was produced in the same procedure as Example 1 except that the crosslinkable linear triphenylamine monomer (chemical formula (9)) in the procedure explained in Example 1 was replaced with 2,7-bis(4,4,5,5-tetramethyl-1,3,2-dioxaborolane-2-yl)-9,9-dioctyl-9H-fluorene (the following chemical formula (12)). The curable polymer is called a second curable polymer.

[Chem. 4]

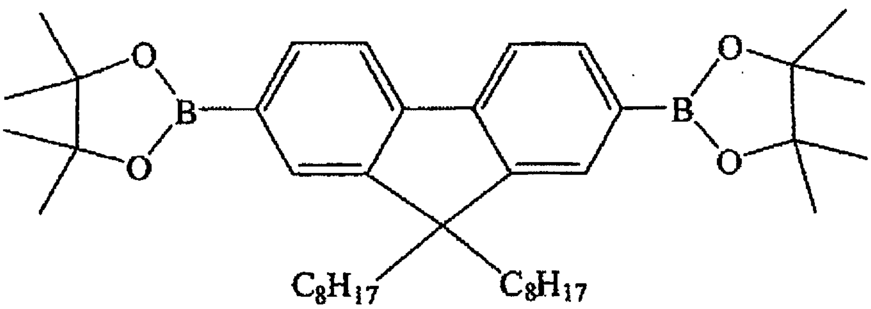

(12)

<Example 3: Third curable polymer including macromolecule doped with holes>

A curable polymer was produced in the same procedure as Example 1 except that the crosslinkable linear triphenylamine monomer (chemical formula (9)) in the procedure explained in Example 1 was replaced with 2,7-bis(4,4,5,5-tetramethyl-1,3,2-dioxaborolane-2-yl)-N-phenyl-9H-carbazole (the following chemical formula (13)). The curable polymer is called a third curable polymer.

[Chem. 5]

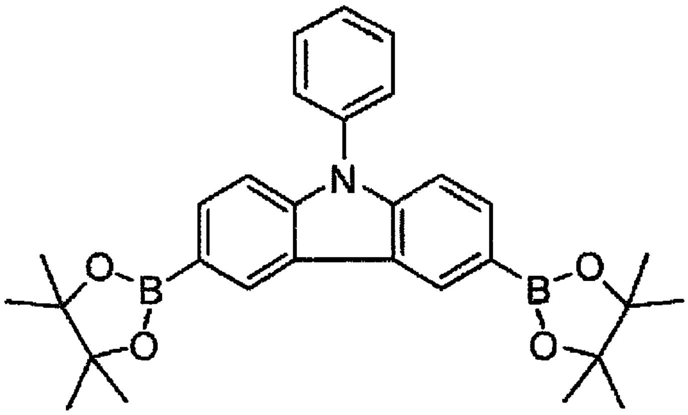

(13)

By the means similar to Example 1, it was confirmed that both the second curable polymer and the third curable polymer were curable polymers doped with holes.

In a conductive film formed by using the second curable polymer, the hole density was $8\pm0.5\times10^{16}$ [pieces/cm$^3$] when the ionic polymerization initiator concentration was 1.0% by mass and $4\pm0.4\times10^{17}$ [pieces/cm$^3$] when the ionic polymerization initiator concentration was 5.0% by mass.

In a conductive film formed by using the third curable polymer, the hole density is $1\pm0.1\times10^{17}$ [pieces/cm$^3$] when the ionic polymerization initiator concentration is 1.0% by mass and $5\pm0.2\times10^{17}$ [pieces/cm$^3$] when the ionic polymerization initiator concentration was 5.0% by mass.

[Evaluation of work function]

A work function of a cured resin was determined with a photoelectron yield spectrometer (Surface Analyzer AC-1 made by RIKEN KEIKI Co., Ltd., irradiated light quantity: 50 nW).

The work function of the film using the first curable polymer was 5.0 eV. The work function of the film using the second curable polymer was 5.2 eV. The work function of the film using the third curable polymer was 5.3 eV. From the results, it can be said that a film having a desired work function can be produced in conformity with the work function of a light emitting layer by changing the type of a conjugating monomer used when a curable polymer is synthesized.

<Comparative Example 1: Curable polymer not doped with holes>

A macromolecule of a curable polymer obtained in the "synthesis of crosslinkable polymer" of Example 1 of 4.2 mg and an ionic polymerization initiator represented by the expression (4) (in the expression, anion X = $(C_6F_5)_4B$) of 0.04 mg (corresponding to 1% by mass of the curable polymer) are dissolved in a toluene of 1.2 ml. The coating solution was applied over an ITO substrate 1.6 mm in width by spin coating under the condition of 300 rpm.

The characteristics of the films after heat-treated over a hot plate under the following three different conditions (D: no heating, E: heating at 120°C for 10 minutes, F: heating at 200°C for 10 minutes) were examined.

[Residual film ratio]

Whereas the residual film ratios of the films of (D) and (E) were 30% or less, the residual film ratio of the film of (F) was 90% or more. Even in the curable polymers to which an initiator of a small amount of 0.1% by mass was added, whereas the residual film ratios of the films of (D) and (E) were 30% or less, the residual film ratio of the film of (F) was 90% or more.

[Hole density $n_0$]

No hole was observed in the film of (D). 5×1017 [pieces/cm$^3$] is obtained in the film of (E) and 1×1018 [pieces/cm$^3$] is obtained in the film of (F). Unlike a conductive film formed by a curable polymer doped with holes, hole doping reaction proceeds more together with curing reaction as a temperature rises. This shows that an unreacted cationic molecule exists in a film after spin-coated. It is highly likely that the unreacted cationic molecule does not entirely finish

the reaction yet by high temperature treatment.

<Example 4>

<Organic light emitting element including hole transport layer formed by using curable polymer doped with holes>

[Production of organic light emitting element]

A film was formed as a first hole transport layer (20 nm) by applying a first curable polymer produced with an ionic polymerization initiator concentration of 5.0% by mass under the conditions described in Example 1 over a glass substrate over which ITO was patterned in a width of 1.6 mm by spin coating, and heating the first curable polymer at 200°C for 10 minutes.

Successively, a film was formed as a second hole transport layer (40 nm) by applying a third curable polymer produced with an ionic polymerization initiator concentration of 5.0% by mass under the conditions described in Example 3 by spin coating, and heating the third curable polymer at 200°C for 10 minutes. Further, the glass substrate was transferred into a vacuum deposition machine and CBP+Ir(piq)3 (40 nm), BAlq (10 nm), Alq3 (30 nm), LiF (film thickness 0.5 nm), and Al (film thickness 100 nm) were deposited in this order.

After the electrodes were formed, the substrate was transferred into a dry nitrogen environment without opening to the atmosphere, sealing was applied by pasting a sealing glass prepared by forming a counterbore of 0.4 mm in an alkali-free glass of 0.7 mm and the ITO substrate with a photocurable epoxy resin, and thus an organic light emitting element of a multilayer structured macromolecule type was produced.

<Comparative Example 2>

<Organic light emitting element including hole transport layer formed by using curable polymer not doped with holes>

As a comparative example to the organic light emitting element produced in Example 4, an organic light emitting element in which a hole transport layer was formed by using a curable polymer not doped with holes was produced. A first hole transport layer (20 nm) and a second hole transport layer (40 nm) in the organic light emitting element of Example 4 were formed by the method shown in Comparative Example 1.

Except that the curable polymer is not doped with holes and the cationic molecule is not separated and removed, the skeleton of the macromolecule and the ionic polymerization initiator are the same as the combination shown in Example 1 in the first hole transport layer and the same as the combination shown in Example 3 in the second hole transport layer. The concentration of the ionic polymerization initiator was set at 1% by mass both in the first and second hole transport layers so that the hole densities of the respective layers might be identical to Example 4. The layers other than the hole transport layers were stacked similarly to Example 4.

<Application example: Performance evaluation of organic light emitting element>

The organic light emitting element of Example 4 and the organic light emitting element of Comparative Example 2 were evaluated at room temperature (25°C) in the atmosphere. The voltage required for a brightness of 3,000 cd/cm$^2$ was 6.0 V in the organic light emitting element of Example 4 and 6.1 V in the organic light emitting element of Comparative Example 2 and almost the same results were obtained. It was shown that an organic light emitting element including a hole transport layer formed by a curable polymer doped with holes according to the present embodiment maintained the same efficiency as before. Further, when the change of brightness was measured under the condition of a constant current value allowing an initial brightness to be 3,000 cd/m$^2$, the time when the brightness became 1,500 cd/m$^2$ was 108 hours in the organic light emitting element of Example 4 and 70 hours in the organic light emitting element of Comparative Example 2. From the above results, it was verified that an organic light emitting element including a hole transport layer formed by a curable polymer doped with holes had a longer service life than before.

Reference Signs List

| | |
|---|---|
| 1 | conjugating main chain |
| 2 | crosslinking group |
| 3 | hole |
| 301 | organic light emitting element |

31 glass substrate
32 anode
33 hole transport layer
34 light emitting layer
35 electron transport layer
36 cathode
37 sealing glass plate
401 hole only element
402 LCR meter

**Claims**

1. A curable polymer including a macromolecule including a main chain having a conjugating monomer and a side chain having a crosslinking group,
wherein the macromolecule is doped with holes.

2. The curable polymer according to Claim 1, wherein the curable polymer further includes an anionic molecule.

3. The curable polymer according to Claim 2,
wherein the curable polymer further includes a cationic molecule; and
a molar concentration of the cationic molecule is 0.1 times or less of a molar concentration of the anionic molecule.

4. The curable polymer according to any one of Claims 1 to 3, wherein the conjugating monomer is one of the following chemical formulae (1) to (3),

[Chem. 1]

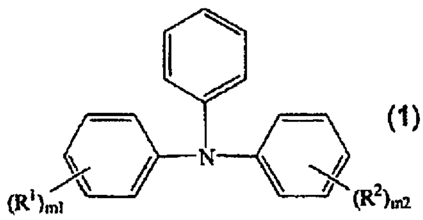
(1)
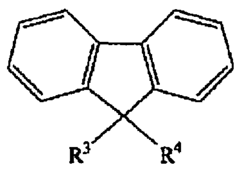
(2)
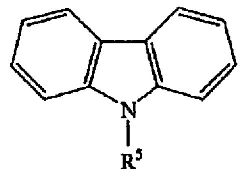
(3)

(in the formulae, $R^1$ to $R^5$ are selected independently from each other from the group consisting of hydrogen, halogen, cyano, nitro, linear, branched, or cyclic alkyl having 1 to 22 carbon atoms, linear, branched, or cyclic alkenyl having 2 to 22 carbon atoms, linear, branched, or cyclic alkynyl having 2 to 22 carbon atoms, aryl having 6 to 21 carbon atoms, heteroaryl having 12 to 20 carbon atoms, aralkyl having 7 to 21 carbon atoms, and heteroarylalkyl having 13 to 20 carbon atoms (each of the groups $R^1$ to $R^5$ is not replaced or is replaced with one or more halogens) and each of m1 and m2 is an integer of 0 to 5 independently from each other).

5. A polymerization liquid including the curable polymer according to any one of Claims 1 to 4.

6. The polymerization liquid according to Claim 5, wherein the polymerization liquid further includes acetylacetonate metal complex.

7. A conductive film including the curable polymer according to any one of Claims 1 to 4.

8. An organic light emitting element including the curable polymer according to any one of Claims 1 to 4 in a hole transport layer.

FIG. 1

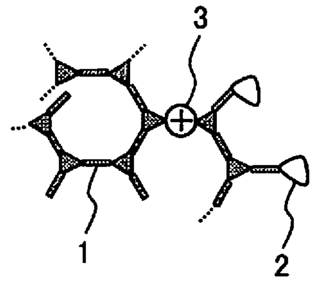


FIG. 2

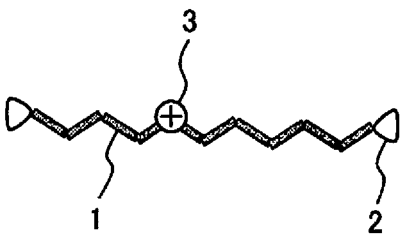


FIG. 3

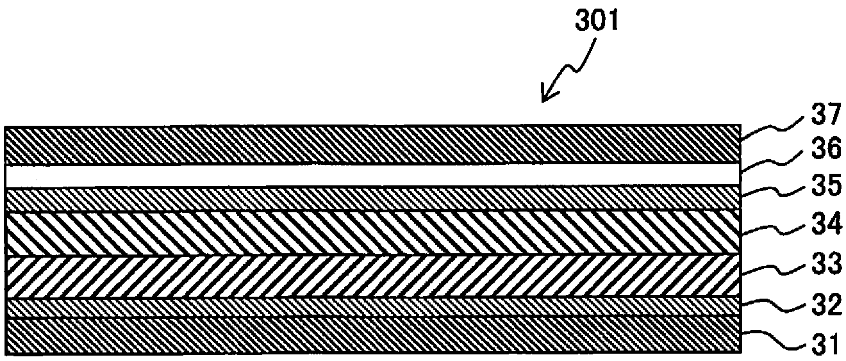

FIG. 4

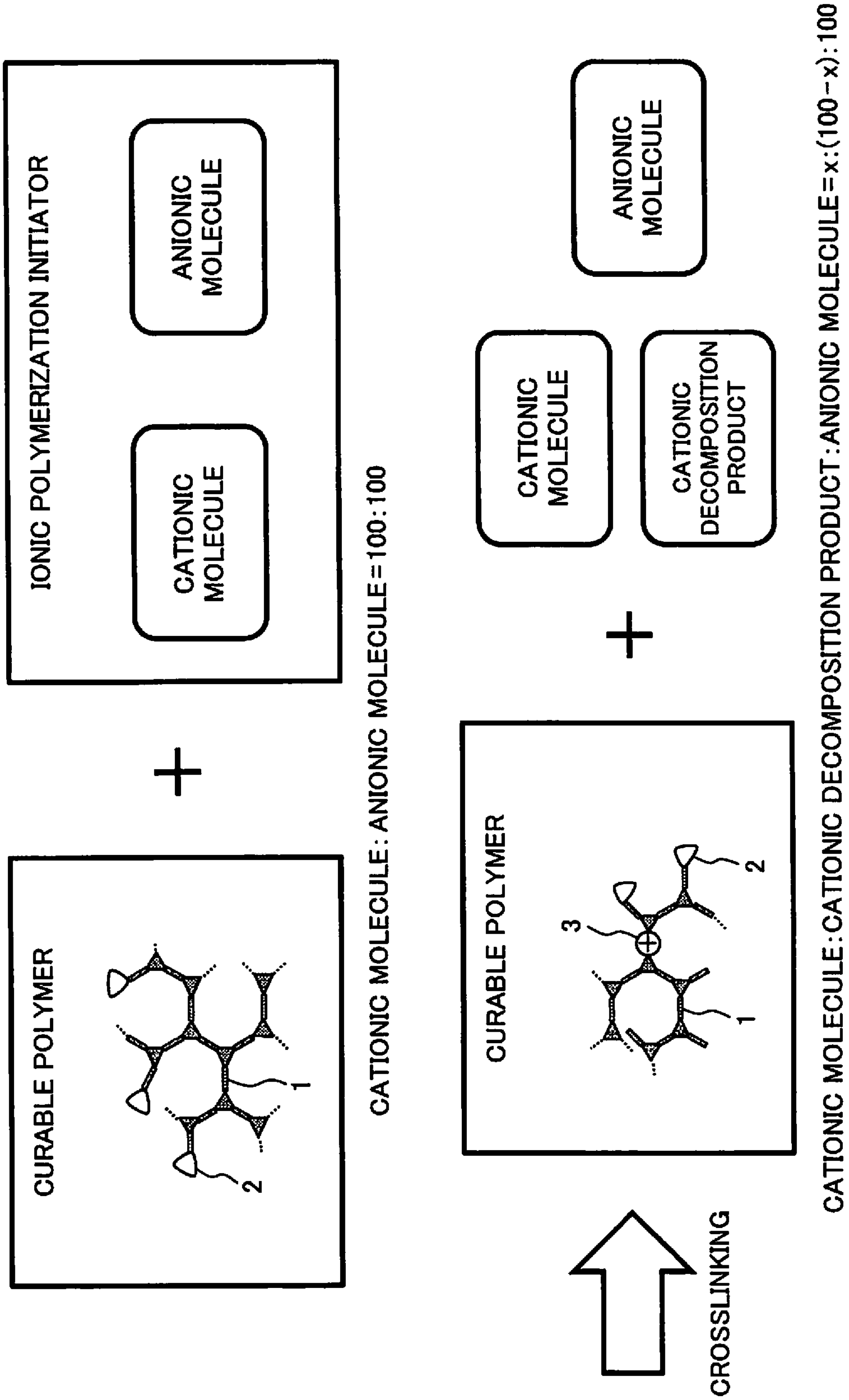
CURABLE POLYMER
1
2
+
IONIC POLYMERIZATION INITIATOR
CATIONIC MOLECULE
ANIONIC MOLECULE
CATIONIC MOLECULE : ANIONIC MOLECULE=100:100
CROSSLINKING
CURABLE POLYMER
1
2
3
+
CATIONIC MOLECULE
CATIONIC DECOMPOSITION PRODUCT
ANIONIC MOLECULE
CATIONIC MOLECULE:CATIONIC DECOMPOSITION PRODUCT:ANIONIC MOLECULE=x:(100−x):100

FIG. 5

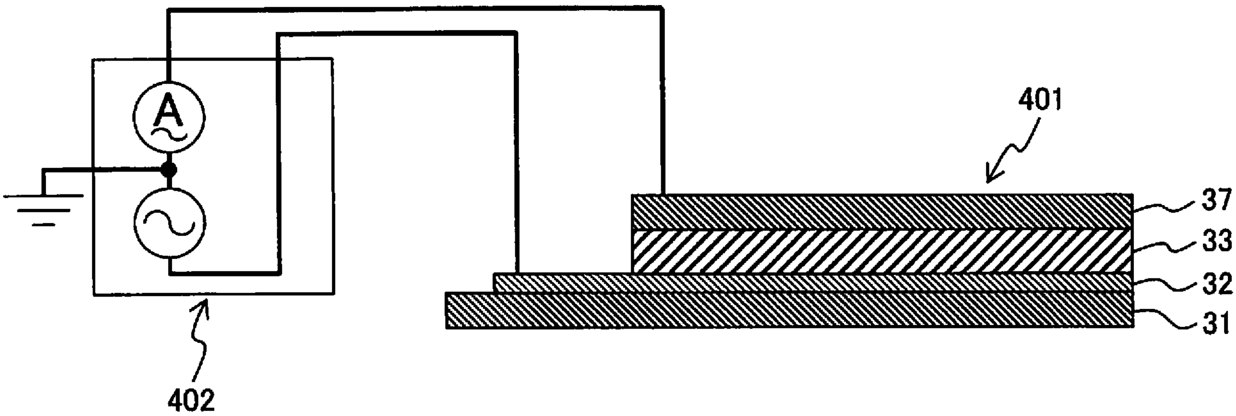

## INTERNATIONAL SEARCH REPORT

International application No. PCT/JP2018/021155

A. CLASSIFICATION OF SUBJECT MATTER
Int.Cl. C08G61/12(2006.01)i, H01L51/50(2006.01)i

According to International Patent Classification (IPC) or to both national classification and IPC

B. FIELDS SEARCHED

Minimum documentation searched (classification system followed by classification symbols)
Int.Cl. C08G61/12, H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2018 |
| Registered utility model specifications of Japan | 1996-2018 |
| Published registered utility model applications of Japan | 1994-2018 |

Electronic data base consulted during the international search (name of data base and, where practicable, search terms used)
CAplus/REGISTRY (STN)

C. DOCUMENTS CONSIDERED TO BE RELEVANT

| Category* | Citation of document, with indication, where appropriate, of the relevant passages | Relevant to claim No. |
|---|---|---|
| X<br>A | PARK, Ji-Young. et al., "Photo-patternable electroluminescent blends of polyfluorene derivatives and charge-transporting molecules", European Polymer Journal, 2008, vol. 44, pp. 3981-3986 | 1, 2, 4, 5, 7<br>3, 6, 8 |
| A | JP 2015-12105 A (HITACHI CHEMICAL CO., LTD.) 19 January 2015, entire text (Family: none) | 1-8 |
| A | JP 2015-192133 A (HITACHI CHEMICAL CO., LTD.) 02 November 2015, entire text (Family: none) | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 27 August 2018 (27.08.2018) | 04 September 2018 (04.09.2018) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

International application No.
PCT/JP2018/021155

C (Continuation). DOCUMENTS CONSIDERED TO BE RELEVANT

| Category* | Citation of document, with indication, where appropriate, of the relevant passages | Relevant to claim No. |
|---|---|---|
| A | JP 2014-19755 A (HITACHI CHEMICAL CO., LTD.) 03 February 2014, entire text (Family: none) | 1-8 |
| A | JP 2016-501915 A (MERCK PATENT GMBH) 21 January 2016, entire text & WO 2014/048542 A1 entire text & US 2015/0255724 A1 | 1-8 |
| A | JP 2012-15539 A (MITSUBISHI CHEMICAL CORP.) 19 January 2012, entire text & EP 2314639 A1 entire text & US 2011/0198573 A1 & KR 10-2011-0039444 A & CN 102105511 A | 1-8 |
| P, A | WO 2017/134905 A1 (HITACHI CHEMICAL CO., LTD.) 10 August 2017, entire text (Family: none) | 1-8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2011099531 A
- JP 2013191867 A